# EUROPEAN PATENT APPLICATION

(11) **EP 2 960 659 A1**
(43) Date of publication of application: **30.12.2015**
(21) Application number: 14174625.5
(22) Date of filing: 27.06.2014
(51) Int. Cl.: G01R 11/04, G01R 15/18, G01R 22/06

(54) **An electrical energy meter and a method for installing it**

(71) Applicant: Efore OYJ, 02600 Espoo (FI)
(72) Inventor: Tommiska, Antti Tapani, 00390 Helsinki (FI); Tötterman, Eric Mikael, 10120 Tähtelä (FI)
(74) Representative: Berggren Oy Ab

(57) **Abstract**

An electrical energy meter comprises a current sensor (101) for measuring electrical current flowing in a first one of electrical cables on the basis of magnetic field produced by the electrical current, a voltage sensor (102) for measuring voltage between the first one of the electrical cables and a second one of the electrical cables, and processing equipment (103) for calculating electrical energy as a function of the measured electrical current and the measured voltage. The voltage sensor comprises contact elements (104, 105) for piercing electrically insulating sheaths of the first and second ones of the electrical cables so as to make electrical contacts with electrically conductive cores of the first and second ones of the electrical cables. Hence, the electrical energy meter can be installed without switching the electrical power off or otherwise disturbing the operation of a system supplied by the electrical cables.

## Description

### Field of the invention

The invention relates to an electrical energy meter for measuring electrical energy transferred by electrical cables. Furthermore, the invention relates to a method for installing an electrical energy meter to electrical cables.

### Background

In many electrical systems, there is a need to measure electrical energy transferred by electrical cables. An inconvenience related to many standard electrical energy meters is that they can be installed only by skilled personnel and their installation can be time consuming. A further inconvenience related to many standard electrical energy meters is that they have to be fixed firmly to a flat surface such as a surface of a wall. Measuring the electrical energy can be based on measurements of one or more electrical currents and one or more voltages. Electrical current can be measured with a shunt resistor but this approach requires cutting an electrical conductor and inserting the shunt resistor to constitute a part of the flowing path of the electrical current. The need for cutting the electrical conductor can be however avoided because the electrical current can be measured based on also the magnetic field produced by the electrical current. Obtaining information about voltage or voltages prevailing between electrically conductive cores of two or more electrical cables is more problematic in this respect, and in conjunction with many electrical energy meters, electrically insulating sheaths of the electrical cables have to be at least in some extent peeled off in order to be able to connect the electrical energy meters to the electrical cables under consideration. Furthermore, typically for safety reasons, the electrical power must be switched off when peeling the insulating sheaths of electrical cables and making the required connections between the electrically conductive cores of the electrical cables and contact terminals of the voltage sensor of an electrical energy meter. Naturally, when shunt resistors are used for current measurements, the electrical power must be switched off when installing the shunt resistors.

Hence, there is a need for electrical energy meters which can be connected to electrical cables without a need to switch off the electrical power or otherwise disturb the operation of the electrical system comprising the electrical cables under consideration.

### Summary

The following presents a simplified summary in order to provide a basic understanding of some aspects of various invention embodiments. The summary is not an extensive overview of the invention. It is neither intended to identify key or critical elements of the invention nor to delineate the scope of the invention. The following summary merely presents some concepts of the invention in a simplified form as a prelude to a more detailed description of exemplifying embodiments of the invention.

In accordance with the invention, there is provided a new electrical energy meter which comprises:
- a current sensor for measuring electrical current flowing in a first one of at least two electrical cables on the basis of magnetic field produced by the electrical current,
- a voltage sensor for measuring voltage between the first one of the electrical cables and a second one of the electrical cables, and
- processing equipment for calculating electrical energy as a function of the measured electrical current and the measured voltage.

The voltage sensor comprises contact elements for piercing the electrically insulating sheaths of the first and second ones of the electrical cables so as to make electrical contacts with the electrically conductive cores of the first and second ones of the electrical cables. Due to the contact elements suitable for piercing the electrically insulating sheaths and thereby forming the electrical contacts, there is no need to peel off the electrically insulating sheaths when installing the above-described electrical energy meter. Thus, the electrical energy meter can be connected to the electrical cables without a need to switch off the electrical power or otherwise disturb the operation of the electrical system comprising the electrical cables under consideration.

In an electrical energy meter according to an exemplifying and non-limiting embodiment of the invention, the current sensor comprises:
- a core structure comprising material having relative permeability µᵣ greater than unity,
- a compensator winding for conducting compensative electrical current,
- a magnetic sensor, e.g. a Hall sensor, for generating a sensor output signal responsive to a resultant magnetic field caused, to the core structure, by the compensative electrical current and by the electrical current flowing in the first one of the electrical cables,
- a controllable current source for supplying the compensative electrical current to the compensator winding on the basis of the sensor output signal so as to adjust the sensor output signal to a reference value that is preferably zero, and
- a signal interface for generating a current-indicator signal proportional to the compensative electrical current and indicative of the electrical current flowing in the first one of the electrical cables.

A current sensor of the kind described above can be constructed to be capable of measuring both alternating and direct currents having different waveforms, i.e. currents having different frequency spectrums with or without a dc-component.

In accordance with the invention, there is provided also a new method for installing an electrical energy meter to two or more electrical cables. The current sensor of the electrical energy meter comprises a ferromagnetic core structure constituting a loop and capable of being opened for allowing a first one of the electrical cables to be introduced into the loop and a controllable current source for producing compensative electrical current so as to at least partly cancel magnetic field caused, to the ferromagnetic core structure, by electrical current flowing in the first one of the electrical cables. The method according to the invention comprises:
- energizing the controllable current source to be capable of producing the compensative electrical current, and subsequently
- closing the ferromagnetic core structure to constitute the loop around the first one of the electrical cables.

The energized controllable current source is capable of at least partly preventing the electrical current flowing in the first one of the electrical cables from magnetizing the ferromagnetic core structure and from causing remanence flux in the ferromagnetic core structure. The remanence flux is unwanted because it deteriorates the accuracy of the current sensor.

A number of exemplifying and non-limiting embodiments of the invention are described in accompanied dependent claims.

Various exemplifying and non-limiting embodiments of the invention both as to constructions and to methods of operation, together with additional objects and advantages thereof, will be best understood from the following description of specific exemplifying embodiments when read in connection with the accompanying drawings.

The verbs "to comprise" and "to include" are used in this document as open limitations that neither exclude nor require the existence of also un-recited features. The features recited in the accompanied dependent claims are mutually freely combinable unless otherwise explicitly stated. Furthermore, it is to be understood that the use of "a" or "an", i.e. a singular form, throughout this document does not exclude a plurality.

### Brief description of the figures

Exemplifying and non-limiting embodiments of the invention and their advantages are explained in greater detail below with reference to the accompanying drawings, in which:
figures 1a, 1b, 1c, and 1d illustrate an electrical energy meter according to an exemplifying embodiment of the invention, and
figure 2 shows a flow chart of a method according to an exemplifying embodiment of the invention for installing an electrical energy meter.

### Description of exemplifying embodiments

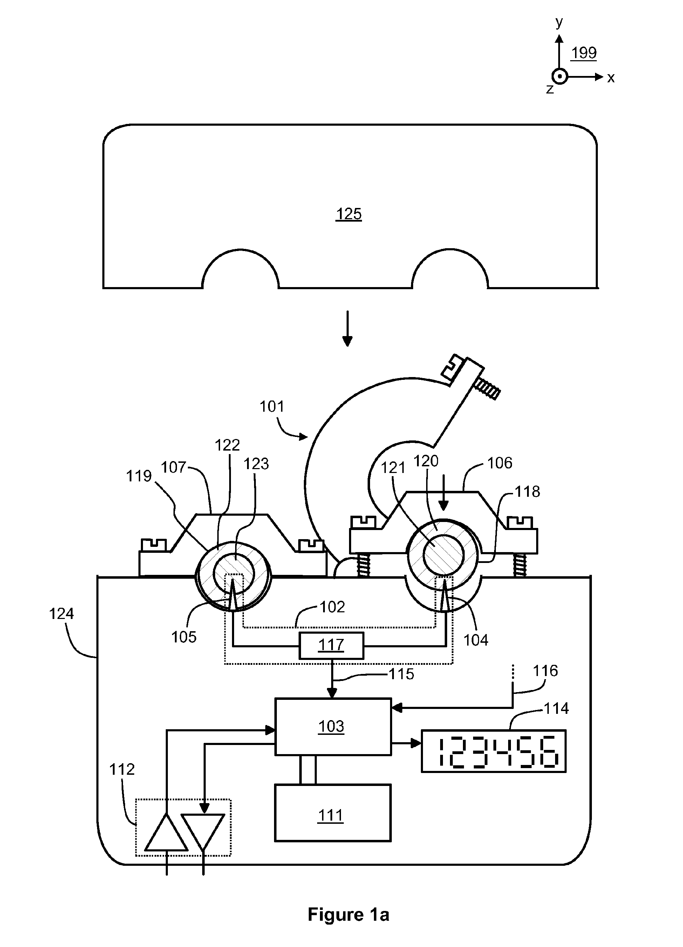

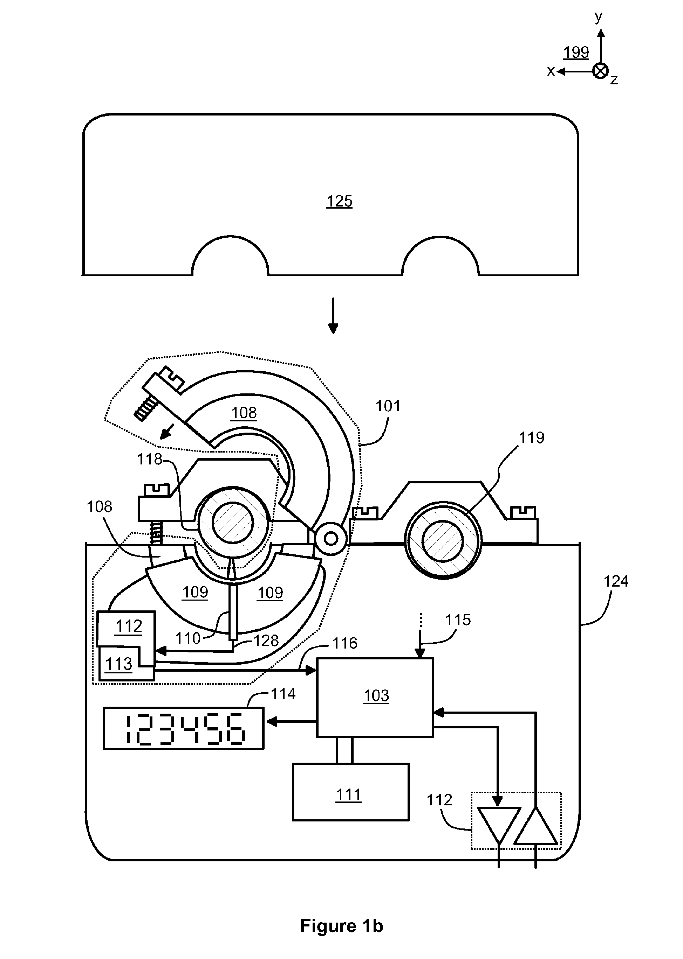

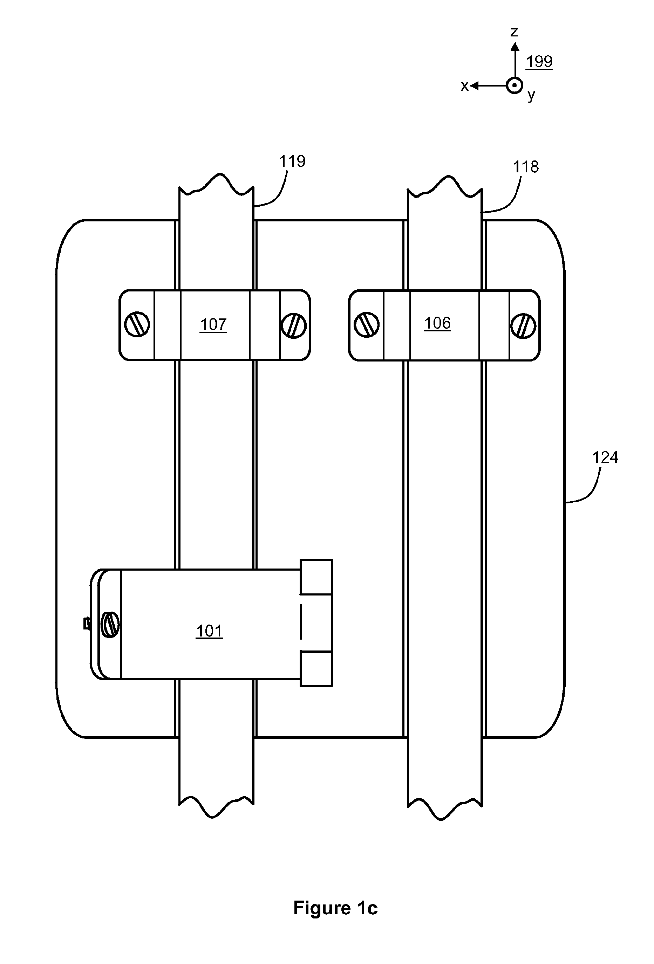

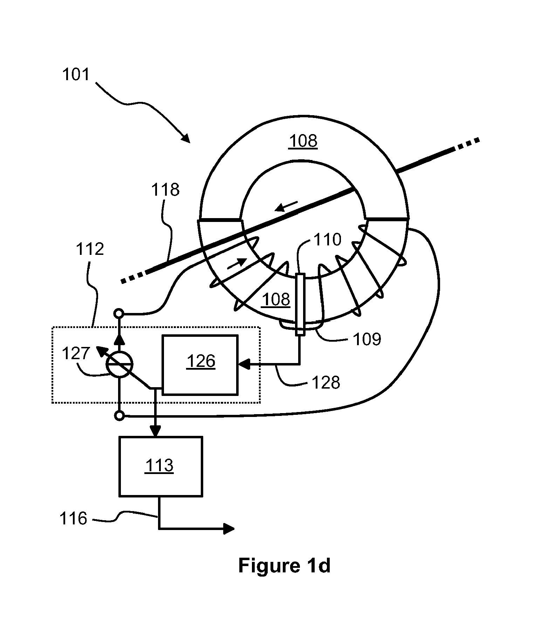

Figure 1 a shows an end-view of an electrical energy meter according to an exemplifying embodiment of the invention, and figure 1b shows another end-view of the electrical energy meter. In figure 1a, the viewing direction is against the positive z-direction of a coordinate system 199, and in figure 1b the viewing direction is against the negative z-direction of the coordinate system 199. Furthermore figures 1 a and 1 b show a schematic illustration of functional elements of the electrical energy meter. Figure 1c shows a top view of the electrical energy meter in a situation where a cover element 125 shown in figures 1 a and 1 b is not present. The electrical energy meter comprises a voltage sensor 102 for measuring voltage between a first electrical cable 118 and a second electrical cable 119. The voltage sensor is illustrated in figure 1 a. The voltage sensor comprises a first sharp contact element 104 for piercing the electrically insulating sheath 120 of the first electrical cable 118 so as to make an electrical contact with the electrically conductive core 121 of the first electrical cable. The voltage sensor 102 comprises a second sharp contact element 105 for piercing the electrically insulating sheath 122 of the second electrical cable 119 so as to make an electrical contact with the electrically conductive core 123 of the second electrical cable. The voltage sensor comprises a signal interface 117 for producing a voltage-indicator signal 115 responsive to the voltage prevailing between the contact elements 104 and 105. The signal interface 117 of the voltage sensor 102 may comprise for example a resistor chain for voltage division and an analog-to-digital converter "ADC". A voltage sensor of the kind described above can be constructed to be capable of measuring both alternating and direct voltages having different waveforms such as e.g. a square wave, a sine wave, a triangle wave etc., i.e. voltages having different frequency spectrums with or without a dc-component. In a case where the signal interface 117 comprises an ADC, the sampling rate is advantageously at least two times the maximum frequency of the frequency spectrum of the voltage to be measured in order to avoid aliasing. The voltage information is advantageously low-pass filtered prior to the AD-conversion so as to avoid the aliasing.

As can be seen from figure 1a, the sharp contact elements 104 and 105 of the voltage sensor 102 are arranged to pierce the electrically insulating sheaths 120 and 122 of the electrical cables 118 and 119 in response to installation of the electrical energy meter to secure relative to the electrical cables. The contact elements 104 and 105 pierce the electrically insulating sheaths 120 and 122 when screws for fastening retaining parts 106 and 107 are tightened. It is, however, also possible that the cover element 125 is shaped so that the contact elements 104 and 105 pierce the electrically insulating sheaths 120 and 122 when the cover element is installed to its place, i.e. the cover element 125 is used for pressing the electrical cables against the sharp contact elements 104 and 105. Furthermore, it is also possible that the sharp contact elements 104 and 105 are fixed to the retaining parts 106 and 107 and there are mutually corresponding contact pads or conducting wires in the retaining parts and in a body element 124 of the electrical energy meter in order to transfer voltage information from the retaining parts to the body element. Hence, the principle of piercing the electrically insulating sheaths 120 and 122 of the electrical cables 118 and 119 for obtaining the voltage information can be implemented in many different ways, for example with screws having sufficiently sharp tips.

The electrical energy meter comprises a current sensor for measuring electrical current flowing in the first electrical cable 118 on the basis of magnetic field produced by the electrical current. It is worth noting that there are many known current sensor types which are suitable for being used in the electrical energy meter under consideration. An exemplifying current sensor of a suitable type is explained below in more details. The current sensor is illustrated in figure 1b and in more details in figure 1d. The current sensor 101 comprises a core structure 108 comprising material, e.g. ferrite or other ferromagnetic material, having relative permeability greater than unity, i.e. µᵣ > 1. As illustrated in figures 1b and 1d, the core structure 108 constitutes a loop and is capable of being opened for allowing the electrical cable 118 to be introduced into the loop. As illustrated in figure 1b, one part of the core structure is hinged with respect to the other part of the core structure but it is naturally also possible that there is e.g. a screw joint instead of the hinge. The current sensor 101 comprises a compensator winding 109 for conducting compensative electrical current. The current sensor 101 comprises a magnetic sensor 110, e.g. a Hall sensor, for generating a sensor output signal 128 responsive to a resultant magnetic field caused, to the core structure 108, by the compensative electrical current and by the electrical current flowing in the first electrical cable 118. The current sensor 101 comprises a controllable current source 112 for supplying the compensative electrical current to the compensator winding 109 on the basis of the sensor output signal 128 so as to adjust the sensor output signal to a reference value that is preferably zero. The current sensor 101 comprises a signal interface 113 for generating a current-indicator signal 116 proportional to the compensative electrical current and indicative of the electrical current flowing in the first electrical cable 118. As illustrated in figure 1d, the controllable current source 112 comprises an output-stage section 127 that is controlled by a control section 126 on the basis of the sensor output signal 128. The signal interface 113 of the current sensor 101 may comprise for example an analog-to-digital converter "ADC". A current sensor of the kind described above can be constructed to be capable of measuring both alternating and direct currents having different waveforms such as e.g. a square wave, a sine wave, a triangle wave etc., i.e. currents having different frequency spectrums with or without a dc-component. In a case where the signal interface 113 comprises an ADC, the sampling rate is advantageously at least two times the maximum frequency of the frequency spectrum of the current to be measured in order to avoid aliasing. The current information is advantageously low-pass filtered prior to the AD-conversion so as to avoid the aliasing.

Another exemplifying current sensor that is suitable for being used in the electrical energy meter under consideration is based on so called flux-gate technology. This current sensor has a closed ferromagnetic core structure, a compensator winding, and a measurement winding. It is based on detecting when the core structure saturates under the influence of the measured current and on the compensative current.

The electrical energy meter comprises processing equipment 103 for calculating electrical energy as a function of the measured electrical current and the measured voltage. The energy can be calculated as a time integral of the product of the instantaneous electrical current and the instantaneous voltage. The processing equipment 103 may comprise one or more programmable processors, and/or one or more dedicated hardware processors such as an application specific integrated circuit "ASIC", and/or one or more field configurable integrated circuits such as a field programmable gate array "FPGA".

An electrical energy meter according to an exemplifying and non-limiting embodiment of the invention comprises an energy-storage 111 for energizing the processing equipment 103, and possibly also the current sensor and/or the voltage sensor and/or other functional elements of the electrical energy meter, e.g. during time intervals when the voltage between the electrical cables 118 and 119 is too low for operating the processing equipment 103. The energy-storage 111 can comprise for example a rechargeable or non-rechargeable battery, and/or a capacitor having sufficient capacitance. In a case where the energy-storage 111 comprises a rechargeable battery and/or a capacitor, the electrical energy meter may comprise a charger circuitry for charging the rechargeable battery and/or the capacitor using the voltage between the electrical cables 118 and 119. It is also possible that the electrical energy meter comprises connectors for receiving operating power from an external power supply system. In some cases, it may not be allowed to take the operating power from the system being measured and thus there is a need for the above-mentioned energy storage and/or the connectors for receiving the operating power and/or power for charging the energy storage from an external power supply system.

In an electrical energy meter according to an exemplifying and non-limiting embodiment of the invention, the processing equipment 103 is arranged to calibrate the current sensor 101 to indicate zero electrical current in response to a situation in which the voltage sensor 102 has indicated substantially zero voltage for a pre-determined amount of time. In many cases, the processing equipment 103 can be arranged to calibrate the current sensor 101 to indicate zero electrical current in response to a situation in which the voltage sensor 102 has indicated that the voltage is below a pre-determined voltage threshold Vₘᵢₙ for a pre-determined amount of time because in many applications the load will not start if the voltage is below a certain limit. The automatic calibration is based on the assumption that the current to be measured is zero when the measured voltage has been zero or below the pre-determined voltage threshold Vₘᵢₙ for a sufficient observation time. In a case of purely resistive loading, the observation time can be short, but in a general case where there can be inductance and/or capacitance in the electrical system comprising the electrical cables 118 and 119, the observation time has to be greater because mere zero-crossings of the voltage do not mean that also the electrical current would be zero simultaneously but the voltage has to be substantially zero for a longer time before one can assume that also the electrical current is zero. It is also possible to arrange the processing equipment 103 to calibrate the current sensor 101 to indicate zero electrical current in response to a situation in which the current sensor has indicated that the electrical current is below a pre-determined current threshold Iₘᵢₙ for a pre-determined amount of time because in conjunction with many applications small electrical current is indicative that the load is nonoperating and the indicated small electrical current can be deemed to be caused by insignificant noise or other disturbances.

An electrical energy meter according to an exemplifying and non-limiting embodiment of the invention comprises a data interface 112 with the aid of which the electrical energy meter can be connected to a data transfer network such as for example a local area network "LAN" or a control area network "CAN", and/or to an external device such as a portable computer. The processing equipment 103 comprises advantageously a memory for storing data expressing the calculated energy, and/or data expressing the time trends of the current, the voltage, and/or the power, and/or data expressing occurred maxima of the current, the voltage, and/or the power, etc. The memory is advantageously a non-volatile memory capable of keeping the stored information also when the power is removed. In this case, the electrical energy meter is capable of storing information for the whole life-time of the electrical energy meter. The memory is advantageously connected to the data interface 112 so that the data can be remotely read through the data transfer network or with the aid of the external device. It is also possible that the data interface is capable of receiving data from the data transfer network and/or from the external device. The received data may comprise for example configuration data and/or control data. The electrical energy meter may further comprise a display 114 for displaying for example the data expressing the calculated energy. As mentioned above, the electrical energy meter may comprise a non-volatile memory capable of storing information indicative of energy measured during the whole life-time of the electrical energy meter.

In an exemplifying and non-limiting case, where the electrical energy meter is designed for measuring electrical energy transferred in a direct voltage system, the electrical energy meter comprises advantageously a power supply circuit, e.g. such as a rectifier bridge, for supplying operating power of the electrical energy meter independently of the polarity of the input voltage of the power supply circuit. Furthermore, the current and voltage sensors are advantageously adapted to operate at both polarities. It is, however, also possible that the current sensor and/or the voltage sensor are/is capable of operating at only one pre-determined polarity. In this case, the processing equipment is advantageously arranged to control a user interface of the electrical energy meter to generate an alarm signal in response to a situation in which the voltage sensor or the current sensor indicates polarity opposite to a pre-determined desired polarity.

An electrical energy meter according to an exemplifying and non-limiting embodiment of the invention comprises a current sensor arranged to measure first electrical current i₁ flowing in a first electrical cable and second electrical current i₂ flowing in a second electrical cable. The electrical energy meter comprises a voltage sensor arranged to measure voltage u₁₂ between the first and second electrical cables and voltage u₁₃ between the first electrical cable and a third electrical cable. The electrical energy meter comprises processing equipment arranged to calculate electrical energy as a function of the measured electrical currents and i₁ and i₂ and the measured voltages U₁₂ and u₁₃. The above-described electrical energy meter is suitable for measuring electrical energy transferred in a three-phase system where no neutral current is present, i.e. the sum of the currents is zero. The instantaneous electrical power p is i₁ × u₁₃ + i₂ × (u₁₃ - u₁₂) = i₁ × (u₁ - u₃) + i₂ × (u₁ - u₃ - u₁ + u₂) = i₁ × u₁ + i₂ × u₂ + i₃ × u₃, where u₁, u₂, and u₃ are the instantaneous phase voltages with respect to the ground and i₃ = - i₁ - i₂. The electrical energy is the time integral of the instantaneous electrical power. The first mathematical expression for the instantaneous electrical power i₁ × u₁₃ + i₂ × (u₁₃ - u₁₂) is valid only when the sum of the currents is zero, i.e. i₃ = - i₁ - i₂. In cases, where there sum of the currents can be non-zero, we have to use the last expression i₁ × u₁ + i₂ × u₂ + i₃ × u₃ which does not rely on assumptions of the kind mentioned above, and we have to measure also the current i₃. Furthermore, information indicative of the phase voltages u₁, u₂, and u₃ with respect to the ground or other entity which constitutes the return path for the non-zero sum current is needed. For obtaining the phase voltages u₁, u₂, and u₃ it is sufficient to measure only one phase voltage, e.g. u₁, and two line-to-line voltages, e.g. u₁₃ and u₁₂, because the other phase voltages can be formed on the basis of the Kirchhoff's voltage law.

In an electrical energy meter according to an exemplifying and non-limiting embodiment of the invention, the processing equipment 103 is arranged to calculate the electrical power as a signed quantity where a positive sign corresponds to a first power flow direction and a negative sign corresponds to a second power flow direction opposite to the first power flow direction. The processing equipment is advantageously arranged to calculate the following quantities: a) the electrical energy in the first power flow direction being a time integral of the electrical power over first time periods when the electrical power is positive, b) the electrical energy in the second power flow direction being a time integral of the electrical power over second time periods when the electrical power is negative, and c) the electrical energy as a signed value being a time integral of the electrical power over the first and second time periods. The ability to calculate the electrical energies in both power flow directions and/or the electrical energy as the signed value may be important e.g. in renewable energy applications where electrical power can be also returned to the grid and the producer receives compensation for that electrical energy.

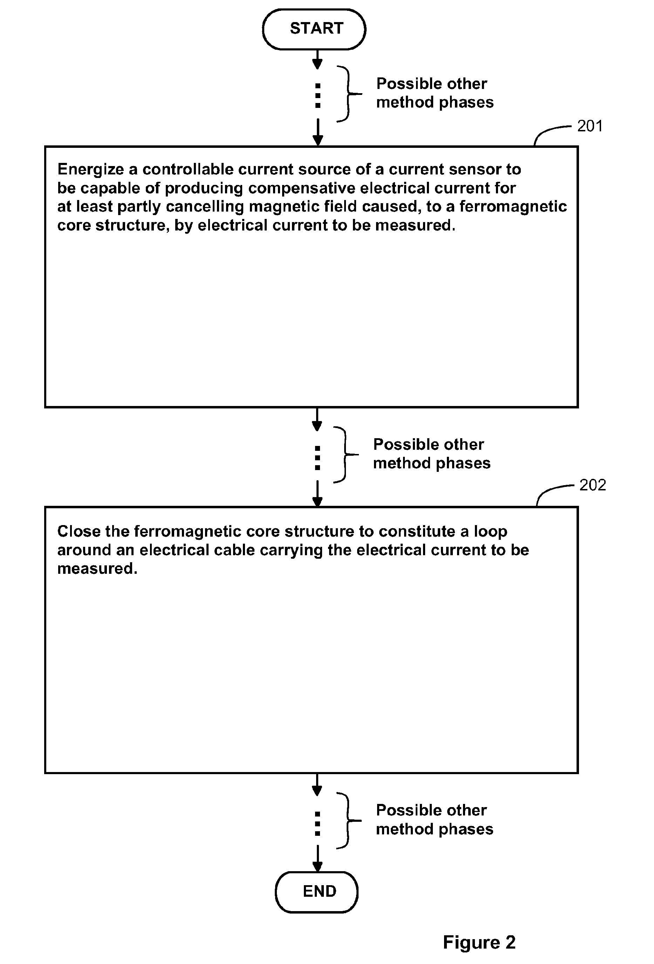

Figure 2 shows a flow chart of a method according to an exemplifying and non-limiting embodiment of the invention for installing an electrical energy meter to two or more electrical cables. The current sensor of the electrical energy meter comprises a ferromagnetic core structure constituting a loop and capable of being opened for allowing a first one of the electrical cables to be introduced into the loop and a controllable current source for producing compensative electrical current so as to at least partly cancel magnetic field caused, to the ferromagnetic core structure, by electrical current flowing in the first one of the electrical cables. The method comprises the following actions:
- action 201: energizing the controllable current source to be capable of producing the compensative electrical current, and subsequently
- action 202: closing the ferromagnetic core structure to constitute the loop around the first one of the electrical cables,
wherein the energized controllable current source is capable of at least partly preventing the electrical current flowing in the first one of the electrical cables from magnetizing the ferromagnetic core structure and from causing remanence flux in the ferromagnetic core structure.

In a method according to an exemplifying and non-limiting embodiment of the invention, the controllable current source is energized by connecting a voltage sensor of the electrical energy meter to at least two of the electrical cables so that contact elements of the voltage sensor pierce electrically insulating sheaths of these electrical cables and make electrical contacts with electrically conductive cores of these electrical cables, wherein the controllable current source is energized by voltage measured with the voltage sensor.

The specific examples provided in the description given above should not be construed as limiting the scope and/or the applicability of the appended claims.

## Claims

1. An electrical energy meter comprising:
- a current sensor (101) for measuring electrical current flowing in a first one of at least two electrical cables on the basis of magnetic field produced by the electrical current,
- a voltage sensor (102) for measuring voltage between the first one of the electrical cables and a second one of the electrical cables, and
- processing equipment (103) for calculating electrical energy as a function of the measured electrical current and the measured voltage,
**characterized in that** the voltage sensor comprises contact elements (104, 105) for piercing electrically insulating sheaths of the first and second ones of the electrical cables so as to make electrical contacts with electrically conductive cores of the first and second ones of the electrical cables.

2. An electrical energy meter according to claim 1, wherein the contact elements are arranged to pierce the electrically insulating sheaths of the first and second ones of the electrical cables in response to installation of the electrical energy meter to secure relative to the first and second ones of the electrical cables.

3. An electrical energy meter according to claim 1 or 2, wherein the electrical energy meter comprises retaining parts (106, 107) each of which being suitable for pressing one of the electrical cables against one of the contact elements and causing the one of the contact elements to pierce the electrically insulating sheath of the one of the electrical cables in response to being installed to secure the one of the electrical cables.

4. An electrical energy meter according to any of claims 1-3, wherein the current sensor (101) comprises:
- a core structure (108) comprising material having relative permeability greater than unity,
- a compensator winding (109) for conducting compensative electrical current,
- a magnetic sensor (110) for generating a sensor output signal responsive to a resultant magnetic field caused, to the core structure, by the compensative electrical current and by the electrical current flowing in the first one of the electrical cables,
- a controllable current source (112) for supplying the compensative electrical current to the compensator winding on the basis of the sensor output signal so as to adjust the sensor output signal to a reference value, and
- a signal interface (113) for generating a current-indicator signal proportional to the compensative electrical current and indicative of the electrical current flowing in the first one of the electrical cables.

5. An electrical energy meter according to claim 4, wherein the core structure (108) constitutes a loop and is capable of being opened for allowing the first one of the electrical cables to be introduced into the loop.

6. An electrical energy meter according to claim 4 or 5, wherein the core structure comprises ferromagnetic material.

7. An electrical energy meter according to any of claims 4-6, wherein the magnetic sensor (110) is a Hall sensor.

8. An electrical energy meter according to any of claims 1-7, wherein the electrical energy meter comprises at least one of the following: a power supply circuit for taking operating power of the electrical energy meter from the first and second ones of the electrical cables, an energy-storage (111) for providing the operating power, connectors for receiving the operating power from an external system other than the first and second ones of the electrical cables.

9. An electrical energy meter according to any of claims 1-7, wherein the processing equipment is arranged to calibrate the current sensor to indicate zero electrical current in response to at least one of the following situations: the voltage sensor has indicated substantially zero voltage for a first pre-determined amount of time, the voltage sensor has indicated voltage less than a pre-determined voltage threshold for a second pre-determined amount of time, the current sensor has indicated current less than a pre-determined current threshold for a third pre-determined amount of time, and wherein the electrical energy meter comprises at least one of the following: an energy-storage (111) for providing operating power of the electrical energy meter, a connector of receiving the operating power from an external system other than the first and second ones of the electrical cables.

10. An electrical energy meter according to any of claims 1-9, wherein the electrical energy meter comprises a power supply circuit for supplying operating power of the electrical energy meter independently of polarity of the voltage between the first one of the electrical cables and a second one of the electrical cables.

11. An electrical energy meter according to any of claims 1-10, wherein the processing equipment is arranged to control a user interface of the electrical energy meter to generate an alarm signal in response to a situation in which polarity of at least one of the following is opposite to a pre-determined desired polarity: the electrical current flowing in the first one of the electrical cables, the voltage between the first and second ones of the electrical cables.

12. An electrical energy meter according to any of claims 1-9, wherein:
- the current sensor is arranged to measure also at least electrical current flowing in at least the second one of the electrical cables,
- the voltage sensor is arranged to measure also at least voltage between the first one of the electrical cables and at least a third one of the electrical cables, and
- the processing equipment is arranged calculate electrical energy as a function of the measured electrical currents and the measured voltages.

13. An electrical energy meter according to any of claims 1-12, wherein the processing equipment is arranged to calculate electrical power as a signed quantity where a positive sign corresponds to a first power flow direction and a negative sign corresponds to a second power flow direction opposite to the first power flow direction, and the processing equipment is arranged to calculate at least one of the following: a) the electrical energy in the first power flow direction being a time integral of the electrical power over first time periods when the electrical power is positive, b) the electrical energy in the second power flow direction being a time integral of the electrical power over second time periods when the electrical power is negative, c) the electrical energy as a signed value being a time integral of the electrical power over the first and second time periods.

14. A method for installing an electrical energy meter to two or more electrical cables, a current sensor of the electrical energy meter comprising a ferromagnetic core structure constituting a loop and capable of being opened for allowing a first one of the electrical cables to be introduced into the loop and a controllable current source for producing compensative electrical current so as to at least partly cancel magnetic field caused, to the ferromagnetic core structure, by electrical current flowing in the first one of the electrical cables, **characterized in that** the method comprises:
- energizing (201) the controllable current source to be capable of producing the compensative electrical current, and subsequently
- closing (202) the ferromagnetic core structure to constitute the loop around the first one of the electrical cables,
wherein the energized controllable current source is capable of at least partly preventing the electrical current flowing in the first one of the electrical cables from magnetizing the ferromagnetic core structure and from causing remanence flux in the ferromagnetic core structure.

15. A method according to claim 14, wherein the controllable current source is energized by connecting a voltage sensor of the electrical energy meter to at least two of the electrical cables so that contact elements of the voltage sensor pierce electrically insulating sheaths of the at least two of the electrical cables and make electrical contacts with electrically conductive cores of the at least two of the electrical cables, the controllable current source being energized by voltage measured with the voltage sensor of the electrical energy meter.
